## Europäisches Patentamt
## European Patent Office
## Office européen des brevets

(19)

(11) Publication number: **0 082 024**
A1

(12) # EUROPEAN PATENT APPLICATION

(21) Application number: **82306710.3**

(22) Date of filing: **15.12.82**

(51) Int. Cl.³: **H 03 F 1/34,** H 03 F 1/08, **H 03 H 11/12**

(30) Priority: **16.12.81  GB 8137941**

(43) Date of publication of application: **22.06.83 Bulletin 83/25**

(84) Designated Contracting States: **DE FR NL**

(71) Applicant: **Racal Recorders Ltd, Western Road, Bracknell RG12 1RG Berkshire (GB)**

(72) Inventor: **Croxford, David John, 233 Laburnum Grove North End, Portsmouth Hampshire (GB)**

(74) Representative: **Foster, David Martyn et al, Mathisen, Macara & Co. Lyon House Lyon Road, Harrow Middlesex HA1 2ET (GB)**

(54) **Improvements in and relating to electrical amplifier arrangements.**

(57) A pre-amplifier arrangement for a magnetic replay head is shown. The amplifier arrangement is neither of the current mode type nor of the voltage mode type but is in the form of an amplifier 5 of inherent very high stability which is connected to receive the input from the head (represented by the inductance L and the resistance r) and with resistive feedback (represented by R). The amount of feedback is insufficient to affect the overall gain of the arrangement. Therefore, the amplifier produces an integral response due to its inherent open loop characteristic and high stability of the amplifier itself. The circuit is analysed to show that it produces increased separation between the low frequency and high frequency poles.

0082024

## IMPROVEMENTS IN AND RELATING TO ELECTRICAL AMPLIFIER ARRANGEMENTS

### BACKGROUND OF THE INVENTION

The invention relates to electrical amplifier circuit arrangements and more specifically to such amplifier circuit arrangements for amplifying electrical signals received from a magnetic replay head such as is used in a tape recorder.

Electrical amplifier circuit arrangements used in such environments need to have a frequency response capable of compensating for the frequency response of the replay head.

### BRIEF SUMMARY OF THE INVENTION

According to the present invention, there is provided an electrical circuit arrangement, comprising an inductive input circuit, amplifier means of high stability, and means providing negative feedback for the amplifier means of insufficient magnitude to affect the overall gain whereby the output/frequency characteristic of the arrangement has a relatively low value low frequency pole and a relatively high value high frequency pole.

According to the invention, there is also provided an arrangement for replaying information recorded magnetically, comprising an inductive magnetic replay head and amplifier means connected to receive the signals therefrom and having high stability and with resistive negative feedback of insufficient magnitude to have significant effect on the overall gain.

### DESCRIPTION OF DRAWINGS

An electrical amplifier circuit arrangement embodying the invention, and arranged to amplify the signal from a magnetic replay head will now be described by way of example with reference to the accompanying drawing in which:

Fig.1 is a circuit diagram of the arrangement;

Fig.2 is a graph showing the frequency response of the arrangement; and

Fig.3 is a circuit diagram of a modified form of the arrangement.

### DESCRIPTION OF PREFERRED EMBODIMENTS

As shown, the magnetic replay head is represented by an inductance having a value L and a resistance having a value r, the impedance of the head being represented by Zi. The head feeds the inverting input of a very high stability amplifier 5 whose "+" input is grounded. A feedback impedance having the value Zf is connected across the amplfiier, and the amplified output is produced at an output terminal 6.

As will be explained in more detail below, the amplifier circuit arrangement primarily obtains its stability by means of the inherent stability of the amplifier 5 itself - due to its construction (preferably monolithic construction) and design, and more specifically the circuit arrangement does not rely for its stability primarily on the provision of a substantial amount of feedback.

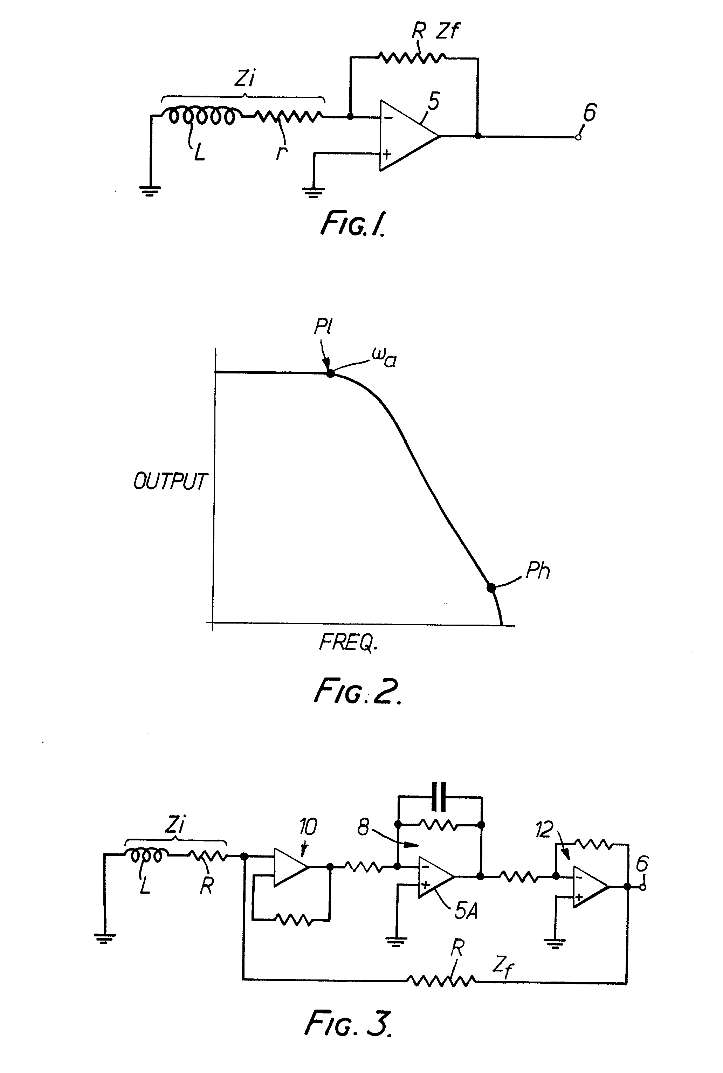

The circuit arrangement will now be analysed, using the parameter values indicated in Figure 1, together with the relationship

$$Vo = A(s).(- V) \tag{1}$$

where Vo is the output voltage and V is the voltage applied at the negative input terminal of the amplifier.

0082024

Therefore,

$$V = \frac{-Vo}{A(s)}$$

However,

$$-V = (\frac{Vi}{Zi} + \frac{Vo}{Zf}) \cdot \frac{Zi \cdot Zf}{Zi+Zf} \tag{2}$$

where Vi is the voltage produced by the head. Therefore, from (1) and (2),

$$(\frac{Vi}{Zi} + \frac{Vo}{Zf}) \cdot \frac{Zi \cdot Zf}{Zi+ZF} = - \frac{Vo}{A(s)}$$

Thus,

$$Vo \cdot (\frac{1}{A(s)} + \frac{Zi}{Zi+Zf}) = -Vi \cdot \frac{Zf}{Zi+Zf}$$

and

$$\frac{Vo}{Vi} = \frac{-Zf}{Zi} \cdot \left[ \frac{Zi/(Zf+Zi)}{1/A(s) + Zi/(Zi+Zf)} \right] \tag{3}$$

$$= -Zf \left[ \frac{A(s)}{Zf+Zi+A(s) \cdot Zi} \right] \tag{4}$$

Let $A(s) = A \cdot \frac{\omega}{s+\omega}$, \tag{5}

where $\omega$ represents the frequency at the low frequency pole shown in Fig.2.

Thus, substituting (5) in (4),

$$\frac{Vo}{Vi} = -Zf \left[ \frac{A \cdot \frac{\omega}{s+\omega}}{Zf+Zs(1+A \cdot \frac{\omega}{s+\omega})} \right]$$

$$= -Zf \left[ \frac{A \cdot \omega}{(Zf+Zi)(s+\omega) + Zi \cdot A\omega} \right]$$

$$= \frac{- A \cdot \omega \cdot R}{(R+sL+r) \cdot (s+\omega)+(sL+r) \cdot A\omega}$$

putting Zf=R and Zi=sL+r.

- 4 -

Therefore,

$$\frac{V_O}{V_i} = \frac{- A.\omega.R}{s^2 L + s(R+r+\omega L) + \omega(R+r) + sLA\omega + rLA.\omega}$$

$$= \frac{- A.\omega.R/L}{s^2 + s\left[(R+r)/L + \omega + A.\omega\right] + \omega(R+r)/L + .Ar/L}$$

$$= \frac{- A. .R/L}{s^2 + s\left[\omega(A+1) + (R+r)L\right] + \omega\left[r(A+1) + R\right]/L} \qquad (6)$$

If $A \gg 1$ and $R \gg r$, (6) can be re-written as

$$\frac{V_O}{V_i} = \frac{A\omega R/L}{s^2 + s(\omega + R/L) + \omega(Ar + R)/L}$$

This gives two turning points for the curve, given by

$$\frac{-(\omega + R/L) \pm \sqrt{(\omega + R/L)^2 - 4(Ar + R)/L}}{2} \qquad (7)$$

However, $R/L \gg \omega$, and therefore (7) can be re-written as

$$\frac{-R/L \pm \sqrt{(R/L)^2 - (4Ar + 4R)/L}}{2}$$

If $Ar \gg R$, this becomes

$$\frac{-R/L \pm \sqrt{(R/L)^2 - 4Ar/L}}{2}$$

The low frequency pole Pl is therefore given by

$$Pl = \frac{-R/L + \sqrt{(R/L)^2 - 4Ar/L}}{2} \qquad (8)$$

and the high frequency pole Ph is given by

$$Ph = \frac{-R/L - \sqrt{(R.L)^2 - 4Ar/L}}{2} \qquad (9)$$

0082024

Equation (8) shows that the low frequency pole tends to zero (that is, 0Hz) as R is increased, while under such condition the high frequency pole tends to R/L.

The amplifier described therefore contrasts with amplifiers of the current mode type which obtain an integral response by virtue of the inductance effect of the replay head and in which the low frequency pole tends to occur at a relatively high frequency (of the order of 1KHz, for example), and also contrasts with amplifiers of the voltage mode type, which obtain an integral response owing to the use of feedback capacitance and in which the high frequency pole tends to be relatively low. The amplifier analysed above obtains its integral response by virtue of its inherent high gain and high stability and uses only a relatively small amount of feedback and, as a result, provides a low frequency pole at a lower frequency than does a pre-amplifier of the current mode type and a high frequency pole at a higher frequency than does a pre-amplifier of the voltage mode type.

The amplifier could also be connected in the differential mode.

Figure 3 shows an alternative construction in which the amplifier 5 of Fig.1 is shown as an amplifier 5A with stabilising feedback 8 and fed from the head L, r through a buffer amplifier 10. A further amplifier stage 12 (of unity gain) is provided to ensure correct polarity and feeds the output terminal 6. Overall feedback is provided via resistor R which corresponds to the feedback provided by resistor R in Fig.1. The difference between the Fig.1 and Fig.3 arrangements, therefore, is that the Fig.1 arrangement obtains its stability by using a low noise, high gain and low cost monolithic integrated amplifier 5, while the Fig.3 arrangement uses an amplifier 5A provided with stabilising feedback and connected in cascade with the buffer 10 and inverting stage 12. In each case, feedback through resistor R provides almost open-loop overall response as shown by the mathematical analysis above (which applies to Fig.3 as well as Fig.1).

## CLAIMS

1.   An electrical circuit arrangement, comprising an inductive input circuit (Zi), amplifier means (5; 5A, 8, 10, 12) of high stability, and means (Zf) providing negative feedback for the amplifier means (5; 5A, 8, 10, 12) of insufficient magnitude to affect the overall gain whereby the output/frequency characteristic of the arrangement has a relatively low value low frequency pole (Pl) and a relatively high value high frequency pole (Ph).

2.   An arrangement according to claim 1, in which the said amplifier means (5) is of inherent high stability.

3.   An arrangement according to claim 2, in which the amplifier means (5) is an amplifier of monolithic construction.

4.   An arrangement according to claim 1, in which the amplifier means comprises an amplifier arrangement (5A, 8, 10, 12) including an amplifier (5A) having stabilising negative feedback (8) of such form and magnitude as to provide the said high stability, and the negative feedback (Zf) of insufficient magnitude to affect the overall gain is connected from the output of the said amplifier arrangement (5A, 8, 10, 12) back to the input thereof.

0082024

5.   An arrangement according to claim 4, in which the said amplifier arrangement (5A, 8, 10 12) comprises a buffer amplifier (10) and a polarity changing amplifier (12) connected in cascade with the amplifier (5A) having the stabilising negative feedback (8).

6.   An arrangement according to any preceding claim, in which the input circuit includes an inductive magnetic replay head (L, r) for replaying information recorded magnetically.

0082024

1/1

Fig.1.

Fig.2.

Fig.3.

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| Y | US-A-4 134 140 (C.E.WRIGHT et al.) *Figures 1-3; page 1, "abstract"; column 2, line 61 to column 4, line 20* | 1-4,6 | H 03 F 1/34<br>H 03 F 1/08<br>H 03 H 11/12 |
| | --- | | |
| Y | ELECTRONICS INTERNATIONAL, vol. 51, no. 16, 3rd August 1978, pages 120,121, New York (USA); C.A.J.VAN DER GEER: "Boosting op amps' roll-off extends range of active filters". *The whole document* | 1-4,6 | |
| | --- | | |
| A | US-A-4 222 012 (K.YOKOYAMA) *Figures 6-8; column 1, lines 42-50; column 3, line 56 - column 4, line 53* | 1-4 | |
| | --- | | TECHNICAL FIELDS SEARCHED (Int. Cl. ³) |
| A | RADIO FERNSEHEN ELEKTRONIK, vol. 27, no. 8, August 1978, pages 491-495, Berlin (DE); R.RADANDT: "Aufbau rauscharmer Vorverstärker für magnetische Abtastsysteme". *Figures 1,2,5; page 491, right-hand column, the complete paragraph: "Vergleich der Gegenkopplungsarten"* | 1-4 | H 03 F<br>H 03 H |
| | ---     -/- | | |

The present search report has been drawn up for all claims

| Place of search | Date of completion of the search | Examiner |
|---|---|---|
| THE HAGUE | 10-03-1983 | TYBERGHIEN G.M.P. |

| DOCUMENTS CONSIDERED TO BE RELEVANT | | | Page 2 |

| Category | Citation of document with indication, where appropriate, of relevant passages | Relevant to claim | CLASSIFICATION OF THE APPLICATION (Int. Cl. 3) |
|---|---|---|---|
| A | WIRELESS WORLD, vol. 79, no. 1455, September 1973, pages 449-450, Letters to the Editor, Hayward Heath (GB); J.L.LINSLEY HOOD: "Audio amplifier design". *Figure on page 449* | 5 | |
| | ----- | | |
| | | | TECHNICAL FIELDS SEARCHED (Int. Cl. 3) |

The present search report has been drawn up for all claims

| Place of search THE HAGUE | Date of completion of the search 10-03-1983 | Examiner TYBERGHIEN G.M.P. |